Europäisches Patentamt

European Patent Office

Office européen des brevets

(19)

(11) Veröffentlichungsnummer: **0 212 054**
**B1**

(12) **EUROPÄISCHE PATENTSCHRIFT**

(45) Veröffentlichungstag der Patentschrift: **20.06.90**

(51) Int. Cl.⁵: **G 03 F 1/00**

(21) Anmeldenummer: **86104299.2**

(22) Anmeldetag: **27.03.86**

(54) **Verfahren zur Herstellung von Masken für die Röntgentiefenlithographie.**

(30) Priorität: **22.08.85 DE 3529966**

(43) Veröffentlichungstag der Anmeldung:
**04.03.87 Patentblatt 87/10**

(45) Bekanntmachung des Hinweises auf die
Patenterteilung:
**20.06.90 Patentblatt 90/25**

(84) Benannte Vertragsstaaten:
**CH DE FR GB IT LI NL SE**

(56) Entgegenhaltungen:
**EP-A-0 057 268      FR-A-2 279 135
EP-A-0 112 509      US-A-4 528 071**

**"INTRODUCTION TO MICROLITHOGRAPHY-
THEORY, MATERIALS, AND PROCESSING",
Editor L.F. THOMPSON et al., The 185th Meeting
of the American Chemical Society, Seattle,
Washington, 20.-25. März 1983, ACS
Symposium, Series 219, Seiten 74-76, American
Chemical Society, Washington, D.C., US**

(73) Patentinhaber: **KERNFORSCHUNGSZENTRUM
KARLSRUHE GMBH
Weberstrasse 5 Postfach 3640
D-7500 Karlsruhe 1 (DE)**

(72) Erfinder: **Ehrfeld, Wolfgang, Dr.
Rentstrasse 27
D-7500 Karlsruhe 41 (DE)**
Erfinder: **Maner, Asim, Dr.
Guntherstrasse 1
D-7513 Stutensee-1 (DE)**
Erfinder: **Münchmeyer, Dietrich, Dr.
Hagäckerstrasse 5
D-7513 Stutensee-3 (DE)**

Courier Press, Leamington Spa, England.

## Beschreibung

Die Erfindung betrifft ein Verfahren zur Herstellung von Masken mit dicken Absorberstrukturen für die Röntgentiefenlithographie gemäß dem Oberbegriff von Anspruch 1.

Ein Herstellungsverfahren dieser Art ist aus der EP—A—0 057 268 bekannt. Dabei wird auf einer Seite eines Substrats eine primäre, dünne Absorberstruktur, z.B. aus Nickel, erzeugt und dann mit einem Positiv-Resist, z.B. PMMA, überdeckt. Nach dem partiellen Bestrahlen, Entwickeln des Resists und anschließendem Galvanisieren, vorzugsweise mit Gold, entsteht auf derselben Seite eine relativ dicke Absorberstruktur, die zu der primären, dünnen und anschließend abzuätzenden Absorberstruktur komplementär ist. Mit einer derartigen Maske können auf röntgentiefenlithographischem Wege Mikrostrukturen erzeugt werden, die eine Dicke bis zu einigen hundert μm aufweisen können. Hinsichtlich der erreichbaren lateralen Abmessungen derartiger Mikrostrukturen sind jedoch dieser Maske Grenzen gesetzt sowohl im Hinblick auf den erforderlichen scharfen Kontrast bei der Betrahlung und Entwicklung des Resists als auch hinsichtlich dem sich hieran anschließenden Galvanisieren in extrem enge Zwischenräume hinein.

Aus der DE—A—32 45 868 ist es für die Herstellung einer Dünnschichtmaske bekannt, eine Absorberstruktur von ca. 0,25 μm auf der einen Seite eines Substrats aufzubringen und auf röntgenlithographischem Wege mittels eines Photonegativ-Lacks eine zweite, zur ersten spiegelbildlichen Absorberstruktur auf der anderen Seite des Substrats zu erzeugen.

Diese zweite Absorberstruktur weist jedoch wegen des begrenzten Auflösungsvermögens von Photonegativ-Lacken ebenfalls nur eine Schichtdicke von ca. 0,25 μm auf. Die Herstellung von Masken mit 9 bis 12 μm dicken Absorberstrukturen, wie sie für die Röntgentiefenlithographie gefordert wird, ist in dieser Druckschrift nicht angesprochen.

Der Erfindung liegt die Aufgabe zu Grunde, ein Verfahren der gattungsgemäßen Art zur Herstellung von Röntgenmasken für die Röntgentiefenlithographie mit dicken Absorberstrukturen in der Größenordnung von 10 μm bereitzustellen, deren kleinste, laterale Abmessungen im μm-Bereich liegen.

Diese Aufgabe wird mit den im Kennzeichen von Anspruch 1 genannten Maßnahmen gelöst. Der hierauf bezogene Anspruch 2 beinhaltet eine vorteilhafte Ausgestaltung dieser Maßnahmen.

Die räumliche Trennung der primären Absorberschicht von der Positiv-Röntgenresistschicht durch die Trägermembran in Verbindung mit der angewendeten Synchrotronstrahlung gestattet die Erzielung des erforderlichen scharfen Kontrasts und bewirkt darüber hinaus, daß die primäre Absorberschicht keinen negativen Einfluß auf die Haftung der komplementären Absorberstruktur an der Membran ausüben kann.

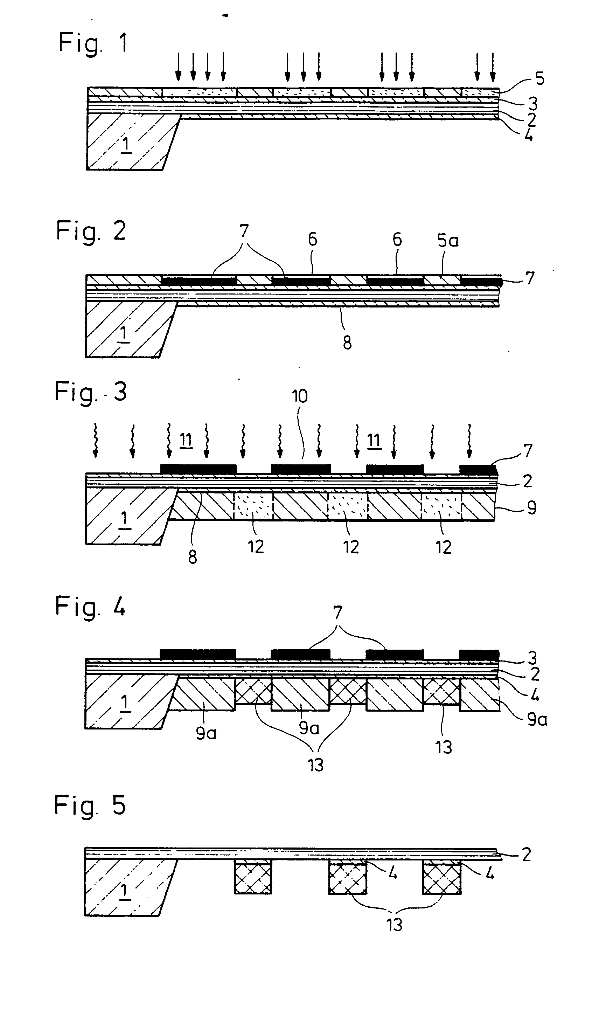

Das erfindungsgemäße Verfahren wird im folgenden anhand der Figuren 1 bis 5 beispielhaft erläutert:

Figur 1 zeigt in stark vergrößertem Maßstab einen Schnitt durch einen stabilen Halterahmen 1 und eine straff darüber gespannte Trägermembran 2 aus 20 μm dickem Beryllium, auf die zunächst beidseitig je eine ca. 30 nm dicke Kupferschicht als Galvanikstartschichten 3, 4 aufgesputtert und dann auf die Schicht 3 mit Spin-Coating eine Eletronenresistschicht 5 aus Polybutensulfon aufgebracht werden. Diese Schicht 5 wird durch partielle Bestrahlung mit einem Elektronenstrahlschreiber und anschließende Entwicklung strukturiert, wodurch eine Resiststruktur mit freien Öffnungen 6 entsteht, deren Dicke etwa 0,3 bis 2 μm betragen kann. In die freien Öffnungen 6 wird galvanisch Kupfer abgeschieden, das die dünne primäre Absorberstruktur 7 bildet (Fig. 2), worauf die Reste der Elektronenresistschicht 5a entfernt werden. Zur Vermeidung von galvanischer Kupferabscheidung am Halterahmen 1 und an der Unterseite 8 der Trägermembran 2,4 werden diese Bereiche zuvor mit einem Schutzlack abgedeckt, der anschließend wieder entfernt wird.

Gemäß Fig. 3 wird dann auf der Unterseite 8 der Trägermembran 2 eine ca. 12 μm dicke Schicht 9 eines Positiv-Röntgenresistmaterials durch In-Situ-Polymerisation von Polymethylmethacrylat aufgetragen und von der Oberseite 10 aus, auf der sich die primäre Absorberstruktur 7 befindet, mit Synchrotronstrahlung 11 mit einer charakteristischen Wellenlänge von 2 nm bestrahlt. Die von der primären Absorberstruktur nicht abgeschatteten, bestrahlten Bereiche 12 werden in einem Entwicklerbad herausgelöst. In diese freien Bereiche 12 wird unter Verwendung der verkupferten Trägermembran 2,4 als Elektrode galvanisch Gold als 10 μm dicke Absorberstruktur 13 abgeschieden (Fig. 4), die zu der primären Absorberstruktur 7 komplementär ist. Anschließend werden die Reste 9a der Röntgenresistschicht 9 entfernt und mit Salpetersäure die primäre Absorberstruktur 7, die Kupferschicht 3 und die Kupferschicht 4 so weit abgeätzt, wie sie nicht von der Absorberschicht 13 aus Gold geschützt wird. Auf diese Weise wird eine Maske für die Röntgentiefenlithographie fertiggestellt, bestehend aus der Röntgenstrahlung nur schwach absorbierenden Trägermembran 2, der dicken metallischen Absorberstruktur 13 und dem diese umschließenden, stabilen Halterahmen 1 (Fig. 5).

## Patentansprüche

1. Verfahren zur Herstellung einer Maske für die Röntgentiefenlithographie, bestehend aus einer die Röntgenstrahlung nur schwach absorbierenden Trägermembran (2) und einer die Röntgenstrahlung stark absorbierenden, metallischen Absorberstruktur (13) als Maskenmuster auf der Trägermembran, bei dem

auf der einen Seite der Trägermembran (Oberseite 10) eine Galvanikschicht (3) aufgebracht und auf dieser das Muster einer primären Dünnschicht-Maske mit einer dünnen, primären Absorberstruktur (7) erzeugt wird,

die zu der herzustellenden Absorberstruktur (13) komplementär ist, worauf

eine Positiv-Röntgenresistschicht (9), deren Schichtdicke etwa der Stärke der herzustellenden Absorberstruktur (13) entspricht, aufgebracht und

mit annähernd paralleler, weicher Röntgenstrahlung (11) bestrahlt wird in der Weise, daß von der primären Absorberstruktur (7) nicht abgeschattete, bestrahlte Bereiche (12) entstehen, die herausgelöst werden, worauf

in die so entstandenen Zwischenräume galvanisch Elemente hoher Ordnungszahl (Absorberstruktur 13) abgeschieden und das restliche Resistmaterial (9a) und die primäre Absorberstruktur (7) entfernt werden, dadurch gekennzeichnet, daß

a) auch auf der anderen Seite der Trägermembran (Unterseite 8) eine Galvanikstartschicht (4) aufgebracht und auf dieser die Positiv-Röntgenresistschicht (9) aufgetragen wird, und daß

b) die Positiv-Röntgenresistschicht (9) von der Oberseite (10) aus, auf der die primäre Absorberstruktur (7) erzeugt wurde, mit Synchrotronstrahlung (11) bestrahlt wird.

2. Verfahren nach Anspruch 1, dadurch gekennzeichnet, daß die Trägermembran (2) über einen die Unterseite (8) umschließenden Halterahmen (1) gespannt wird.

**Revendications**

1. Procédé pour fabriquer un masque destiné à la lithographie en profondeur par rayons X, masque constitué d'une membrane porteuse (2) n'absorbant que faiblement les rayons X et par une structure absorbante métallique (13) absorbant fortement les rayons X et constituant un masque sur la membrane porteuse, procédé dans lequel, sur une des faces de la membrane porteuse (face supérieure 10) est rapportée une couche galvanique (3) et sur celle-ci est obtenu le dessin d'un masque primaire à couche mince avec une structure absorbante primaire mince (7) qui est complémentaire de la structure absorbante (13) à réaliser, après quoi une couche positive (9) résistante aux rayons X et dont l'épaisseur correspond à peu près à l'épaisseur de la structure absorbante (13) à réaliser, est rapportée et irradiée avec des rayons X faibles (11) approximativement parallèles de façon à irradier les zones (12) non protégées par la structure absorbante primaire (7) et qui sont éliminées, après quoi dans les espaces intermédiaires ainsi créés, des éléments de nombres atomiques élevés sont déposés galvaniquement (structure absorbante 13), et le matériau résistant restant (9a) ainsi que la structure absorbante primaire (7) sont enlevés, procédé caractérisé en ce que:

a) une couche galvanique de départ (4) est également déposée sur l'autre face de la membrane porteuse (face inférieure 8), et sur cette couche est rapportée la couche positive (9) résistante aux rayons X,

b) la couche positive (9) résistante aux rayons X est irradiée à partir de la face supérieure (10), sur laquelle a été obtenue la structure absorbante primaire (7), avec un rayonnement synchrotron (11).

2. Procédé selon la revendication 1, caractérisé en ce que la membrane porteuse (2) est tendue sur un cadre de maintien (1) entourant la face inférieure (8).

**Claims**

1. Process for the production of a mask for deep X-ray lithography, comprising a carrier membrane (2), which only slightly absorbs the X-radiation, and a metallic absorber structure (13), which, substantially absorbs the X-radiation and serves as the design for the mask on the carrier membrane, wherein a galvanic layer (3) is applied to one surface of the carrier membrane (upper surface 10), and the design for a primary thin-layer mask is produced on said galvanic layer using a thin, primary absorber structure (7), which is complementary to the absorber structure (13) which is to be produced, a positive X-ray resist layer (9) being applied to said absorber structure (13), and the layer thickness of said X-ray resist layer corresponding substantially to the thickness of the absorber structure (13) which is to be produced, and said X-ray resist layer is irradiated with approximately parallel, soft X-radiation (11) in such a manner that irradiated regions (12) are produced, which are not shaded by the primary absorber structure (7) and are eliminated, whereupon elements of a high ordinal number (absorber structure 13) are galvanically deposited into the resultant intermediate spaces, and the remaining resist material (9a) and the primary absorber structure (7) are removed, characterised in that

a) a galvanic start layer (4) is also applied to the other surface of the carrier membrane (lower surface 8), and the positive X-ray resist layer (9) is applied to said galvanic start layer, and in that

b) the positive X-ray resist layer (9) is irradiated with synchrotron radiation (11) from the upper surface (10), on which the primary absorber structure (7) was produced.

2. Process according to claim 1, characterised in that the carrier membrane (2) is stretched over a retaining frame (1), which surrounds the lower surface (8).

Fig. 1

Fig. 2

Fig. 3

Fig. 4

Fig. 5